# EUROPEAN PATENT APPLICATION

(11) **EP 4 709 078 A1**
(43) Date of publication of application: **11.03.2026**
(21) Application number: 25190887.7
(22) Date of filing: 22.07.2025
(51) Int. Cl.: H10B 80/00, H10W 70/40

(54) **STACKED SEMICONDUCTOR DIE ARCHITECTURE WITH REDISTRIBUTION LAYERS ON DIES STACKED ORTHOGONAL TO A BASE DIE OR SUBSTRATE**

(30) Priority: 09.09.2024 US 202418828130
(71) Applicant: Intel Corporation, Santa Clara, CA 95054 (US)
(72) Inventor: Walczyk, Joe F., Tigard, 97224 (US); Tadayon, Pooya, Portland, 97225 (US); Brun, Xavier Francois, Hillsboro, 97124 (US)
(74) Representative: Goddar, Heinz J.

(57) **Abstract**

Microelectronic assembly architectures including a die stack in which each die includes a redistribution layer, and the die stack is positioned such that the face of each die is perpendicular to a face of a base, are provided. Each die has a first face and a second face opposite the first face, and an edge extending between the first and second faces. A redistribution layer is deposited on the first face of each die. The faces of each die in the die stack are parallel to the faces of the other dies. The die stack is positioned on the base such that the faces of each die are orthogonal to the face of the base. Each die can have a conductive contact on a bottom edge, and the conductive contact can be coupled to the respective redistribution layer on the die and to a conductive contact on the base.

## Description

### Background

Electronic circuits commonly fabricated on a wafer of semiconductor material, such as silicon, are called integrated circuits (ICs). The wafer with such ICs is typically cut into numerous individual dies. The dies may be packaged into an IC package containing one or more dies along with other electronic components. IC dies are conventionally coupled to a package substrate for mechanical stability and to facilitate connection to other components, such as circuit boards.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 provides a view of stacked semiconductor die architecture, in accordance with some embodiments.
FIG. 2A-2B are a flow diagram of a method of fabricating a stacked semiconductor die architecture with redistribution layers on dies stacked orthogonal to a base die or substrate, in accordance with some embodiments.
FIGS. 3A-3J provide cross-sectional views at various stages in the fabrication of an example stacked semiconductor die architecture with redistribution layers on dies stacked orthogonal to a base die or substrate, in accordance with some embodiments.
FIGS. 4A-4D provide cross-sectional views at various stages in the fabrication of an example stacked semiconductor die architecture with redistribution layers on dies stacked orthogonal to a base die or substrate, in accordance with some embodiments.
FIG. 5 provides an isometric views of an example stacked semiconductor die architecture with redistribution layers on dies stacked orthogonal to a base die or substrate, in accordance with some embodiments.
FIG. 6 is a top view of a wafer and dies that may be included in a microelectronic assembly with a die stack in accordance with any of the embodiments disclosed herein, according to some embodiments of the present disclosure.
FIG. 7 is a side, cross-sectional view of an IC device that may be included in a microelectronic assembly with a die stack in accordance with any of the embodiments disclosed herein, according to some embodiments of the present disclosure.
FIG. 8 is a side, cross-sectional view of an IC device assembly that may include a die stack in accordance with any of the embodiments disclosed herein, according to some embodiments of the present disclosure.
FIG. 9 is a block diagram of an example communication device that may include a microelectronic assembly with a die stack in accordance with any of the embodiments disclosed herein, according to some embodiments of the present disclosure.

### Detailed Description

Microelectronic assemblies, and related devices and methods, are disclosed herein. For example, in some embodiments, a microelectronic assembly may include a base die and a die stack positioned on a top face of the base die. The die stack includes a first die having a first face, a second face, and a bottom edge extending between the first face and the second face, a conductive contact on the bottom edge of the first die, a redistribution layer on the first face of the first die coupled to the conductive contact, a second die having a first face and a second face opposite the first face, the second face of the second die parallel to the first face of the first die, and a spacer layer between the first face of the first die and the second face of the second die. The die stack is coupled to the top face of the base die with the first and second faces of the first die and the first and second faces of the second die substantially perpendicular to the top face of the base die. The conductive contact on the bottom edge of the first die is coupled to a solder on the top face of the base die.

For purposes of illustrating IC packages described herein, it is important to understand phenomena that may come into play during assembly and packaging of ICs. The following foundational information may be viewed as a basis from which the present disclosure may be properly explained. Such information is offered for purposes of explanation only and, accordingly, should not be construed in any way to limit the broad scope of the present disclosure and its potential applications.

The trend in the computer industry is to increase device performance and memory, and to decrease power consumption and footprint. An IC package can include IC dies stacked to improve performance and save space. A die stack in an IC package refers to multiple dies stacked and interconnected to function as a single unit. For example, current solutions for increasing memory include increasing memory die size and increasing the number of memory die in a die stack. Note that the dies in a die stack can be any type of die, including, for example, memory dies, logic dies, analog dies, power management dies, interface dies, mixed-signal dies, and sensor dies. Generally, each die in a die stack is parallel to a base die, and the dies are interconnected using conductive interconnects extending through the dies (e.g., conductive traces and conductive vias). The base die is used for power delivery to dies in the die stack, and for input/output to and from dies in the stack. Stacking dies saves space, allowing for a more compact IC design. Also, by stacking the dies, the distance between interconnected components can be reduced, leading to faster data transfer rates and lower power usage. However, as the stack grows taller, it can become difficult to deliver power to the uppermost die(s) in the stack. Additionally, as the stack grows taller, heat removal from the stack can become problematic. Thus, die stack size is limited by power and heat removal constraints.

In a general sense, any typical IC die includes a substrate, an active region in the substrate comprising transistors and other active circuitry, and a metallization stack over the substrate, sharing a contact area with the active region. The metallization stack is the region of the IC die in which the individual devices of the active region (e.g., transistors, capacitors, resistors, etc.) are interconnected with conductive traces and conductive vias.

Conventionally, IC dies may be stacked within a package such that the IC dies are parallel to each other, with the active circuitry disposed in planes parallel to the contacting areas of adjacent IC dies. Such architecture suffers from certain inherent limitations. For example, compute IC dies comprising high-performance compute circuitry that generates a lot of heat have to be placed on the top of any such stack so that heat can be dissipated properly. In general, as stated above, die stack size is limited by power and heat removal constraints. Such placement limits the number of high-power compute IC dies that can be placed in a package having a limited (or constrained) footprint.

Embodiments of the present disclosure aim to improve on the die stack limitations by positioning the die stack so that the dies in the stack are stacked sideways over a face of a base (e.g, disposed such that die faces of the dies in the stack are in planes perpendicular to the face of the base, rather than parallel with the base). That is, the die stack is positioned orthogonal to the base, in a "sliced bread" type configuration. When the dies in the die stack are stacked sideways (e.g., orthogonal or perpendicular) to the base, each die can be connected directly to the base, without connections routed by or through other dies in the die stack. Thus, in contrast to other arrangements in which the die stack is parallel to the base and connections are routed through or along the entire die stack from the base to reach the uppermost dies, when the dies in the die stack are orthogonal to the base, each base-to-die connection is direct and there is no uppermost die. When the dies in the die stack are perpendicular to the base, the base can deliver power to each die in the die stack individually. Similarly, input/output communication can occur directly between each die in the die stack and the base. The base can be a base die or a substrate (e.g., a package substrate).

Additionally, a redistribution layer can be added to each a face of each die in the die stack. A redistribution layer includes a layer of insulator material in which conductive interconnects (i.e., traces and vias of conductive materials) are distributed to provide electrical connectivity. The electrical connectivity can include connectivity from the base (e.g., base die or substrate) to each die in the die stack. In general, a redistribution layer is used to re-route contact points from the surface of the base die to various points on a die stack die slice, which in turn allows higher contact density in the die stack. A redistribution layer can be an organic material compatible with the underlying dielectric (e.g., SiN and SiO₂) of the die. The insulator material of a redistribution layer can be a polyimide, a benzocyclobutene (BCB), a polybenzoxaole (PBO) or other insulator material.

Accordingly, embodiments of microelectronic assemblies are discussed herein include creating a die stack in which a face of each die includes a redistribution layer, and positioning the die stack such that the face of each die in the stack including the redistribution layer is perpendicular to a face of a base (e.g., base die or substrate). In particular, each die includes a thin layer of silicon and having a first face, a second face opposite the first face, and an edge extending between the first and second face. A redistribution layer is deposited on the first face of each die in the die stack. The die stack includes multiple dies, with the faces of each die parallel to the faces of the other dies in the die stack. The die stack is positioned on the base such that the faces of each die are substantially perpendicular to the face of the base, while a bottom edge of each die is substantially parallel to the face of the base. Each die in the die stack can have a conductive contact on a bottom edge of the die, between the respective die and the face of the base, and the conductive contact on each die in the die stack can be coupled to the respective redistribution layer on the die as well as to a conductive contact on the base. The conductive contact on each die can be coupled to the conductive contact on the base via an interconnect. The interconnect can be a solder joint, such as a solder bump or solder ball. The number of dies in a die stack can be modular and can be adjusted depending on the application. In some examples, multiple die stacks can be coupled to the base, with a space between each die stack, allowing for efficient heat removal.

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, a "package" and an "IC package" are synonymous, as are a "die" and an "IC die." The terms "top" and "bottom" may be used herein to explain various features of the drawings, but these terms are simply for ease of discussion, and do not imply a desired or required orientation. As used herein, the term "insulating" means "electrically insulating," unless otherwise specified.

Although certain elements may be referred to in the singular herein, such elements may include multiple sub-elements. For example, "a dielectric material" may include one or more dielectric materials or "an insulator material" may include one or more insulator materials. The terms "oxide," "carbide," "nitride," etc. refer to compounds containing, respectively, oxygen, carbon, nitrogen, etc. The term "high-k dielectric" refers to a material having a higher dielectric constant than silicon oxide, while the term "low-k dielectric" refers to a material having a lower dielectric constant than silicon oxide. The term "insulating" and variations thereof (e.g., "insulative" or "insulator") means "electrically insulating," the term "conducting" and variations thereof (e.g., "conductive" or "conductor") means "electrically conducting," unless otherwise specified. With reference to optical signals and/or devices, components and elements that operate on or using optical signals, the term "conducting" can also mean "optically conducting." When two materials or layers are described to be "in contact" this may mean that the two materials or layers are in physical contact, e.g., in direct physical contact, possibly with an interface layer formed as a result of said contact. The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

In some embodiments, the IC dies disclosed herein may comprise substantially monocrystalline semiconductors, such as silicon or germanium, as a base material (e.g., substrate, body) on which integrated circuits are fabricated with traditional semiconductor processing methods. The semiconductor base material may include, for example, N-type pr P-type materials. Dies may include, for example, a crystalline base material formed using a bulk silicon (or other bulk semiconductor material) or a semiconductor-on-insulator (SOI, e.g., a silicon-on-insulator) structure. In some other embodiments, the base material of one or more of the IC dies may comprise alternate materials, which may or may not be combined with silicon, that include but are not limited to germanium, indium antimonide, lead telluride, indium arsenide, indium phosphide, gallium arsenide, indium gallium arsenide, gallium antimonide, or other combinations of group III-N, group III-V, group II-VI, or group IV materials. In yet other embodiments, the base material may comprise compound semiconductors, for example, with a first sub-lattice of at least one element from group III of the periodic table (e.g., Al, Ga, In), and a second sub-lattice of at least one element of group V of the periodic table (e.g., P, As, Sb). In yet other embodiments, the base material may comprise an intrinsic IV or III-V semiconductor material or alloy, not intentionally doped with any electrically active impurity; in alternate embodiments, nominal impurity dopant levels may be present. In still other embodiments, dies may comprise a noncrystalline material, such as polymers; for example, the base material may comprise silica-filled epoxy. In other embodiments, the base material may comprise high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, the base material may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphide, and black phosphorus, each of which may possibly be doped with one or more of gallium, indium, aluminum, fluorine, boron, phosphorus, arsenic, nitrogen, tantalum, tungsten, and magnesium, etc. Although a few examples of the material for dies are described here, any material or structure that may serve as a foundation (e.g., base material) upon which IC circuits and structures as described herein may be built falls within the spirit and scope of the present disclosure.

In various embodiments, elements associated with an IC may include, for example, transistors, diodes, power sources, resistors, capacitors, inductors, sensors, transceivers, receivers, antennas, etc. In various embodiments, elements associated with an IC may include those that are monolithically integrated within an IC, mounted on an IC, or those connected to an IC. The ICs described herein may be either analog or digital and may be used in a number of applications, such as microprocessors, optoelectronics, logic blocks, audio amplifiers, etc., depending on the components associated with the IC. The ICs described herein may be employed in a single IC die or as part of a chipset for executing one or more related functions in a computer.

In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of an electrically conductive material for providing electrical connectivity to one or more elements associated with the IC or/and between various such elements. In such cases, the term "interconnect" may refer to both conductive traces (also sometimes referred to as "lines," "wires," "metal lines" or "trenches") and conductive vias (also sometimes referred to as "vias" or "metal vias"). Sometimes, electrically conductive traces and vias may be referred to as "conductive traces" and "conductive vias", respectively, to highlight the fact that these elements include electrically conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PCI. In such cases, the term "interconnect" may refer to optical waveguides (e.g., structures that guide and confine light waves), including optical fiber, optical splitters, optical combiners, optical couplers, and optical vias.

The term "conductive trace" may be used to describe an electrically conductive element isolated by an insulating material. Within IC dies, such insulating material comprises interlayer low-k dielectric that is provided within the IC die. Within package substrates, and printed circuit boards (PCBs) such insulating material comprises organic materials such as Ajinomoto Buildup Film (ABF), polyimides, or epoxy resin. Such conductive lines are typically arranged in several levels, or several layers, of metallization stacks.

The term "conductive via" may be used to describe an electrically conductive element that interconnects two or more conductive lines of different levels of a metallization stack. To that end, a via may be provided substantially perpendicularly to the plane of an IC die/chip or a support structure over which an IC structure is provided and may interconnect two conductive lines in adjacent levels or two conductive lines in non-adjacent levels.

The term "package substrate" may be used to describe any substrate material that facilitates the packaging together of any collection of semiconductor dies and/or other electrical components such as passive electrical components. As used herein, a package substrate may be formed of any material including, but not limited to, insulating materials such as resin impregnated glass fibers (e.g., PCB or Printed Wiring Boards (PWB)), glass, ceramic, silicon, silicon carbide, etc. In addition, as used herein, a package substrate may refer to a substrate that includes buildup layers (e.g., ABF layers).

The term "metallization stack" may be used to refer to a stack of one or more interconnects for providing connectivity to different circuit components of an IC die/chip and/or a package substrate.

As used herein, the term "pitch" of interconnects refers to a center-to-center distance between adjacent interconnects.

In context of a stack of dies coupled to one another or in context of a die coupled to a package substate or base die, the term "interconnect" may also refer to, respectively, die-to-die (DTD) interconnects and die-to-package substrate (DTPS) interconnects. In some embodiments, DTPS interconnects can also refer to die-to-base-die interconnects.

Although not specifically shown in all of the present illustrations in order to not clutter the drawings, when DTD or DTPS interconnects are described, a surface of a first die may include a first set of conductive contacts, and a surface of a second die, a package substrate, or base die may include a second set of conductive contacts. One or more conductive contacts of the first set may then be electrically and mechanically coupled to some of the conductive contacts of the second set by the DTD or DTPS interconnects.

The DTPS interconnects disclosed herein may take any suitable form. In some embodiments, a set of DTPS interconnects may include solder (e.g., solder bumps or balls that are subject to a thermal reflow to form the DTPS interconnects). DTPS interconnects that include solder may include any appropriate solder material, such as lead/tin, tin/bismuth, eutectic tin/silver, ternary tin/silver/copper, eutectic tin/copper, tin/nickel/copper, tin/bismuth/copper, tin/indium/copper, tin/zinc/indium/bismuth, or other alloys. In some embodiments, a set of DTPS interconnects may include an anisotropic conductive material, such as an anisotropic conductive film or an anisotropic conductive paste. An anisotropic conductive material may include conductive materials dispersed in a non-conductive material. In some embodiments, an anisotropic conductive material may include microscopic conductive particles embedded in a binder or a thermoset adhesive film (e.g., a thermoset biphenyl-type epoxy resin, or an acrylic-based material). In some embodiments, the conductive particles may include a polymer and/or one or more metals (e.g., nickel or gold). For example, the conductive particles may include nickel-coated gold or silver-coated copper that is in turn coated with a polymer. In another example, the conductive particles may include nickel. When an anisotropic conductive material is uncompressed, there may be no conductive pathway from one side of the material to the other. However, when the anisotropic conductive material is adequately compressed (e.g., by conductive contacts on either side of the anisotropic conductive material), the conductive materials near the region of compression may contact each other so as to form a conductive pathway from one side of the film to the other in the region of compression.

The DTD interconnects may take any suitable form. In some embodiments, some or all of the DTD interconnects in a microelectronic assembly or an IC package as described herein may be metal-to-metal interconnects (e.g., copper-to-copper interconnects, or plated interconnects). In such embodiments, the conductive contacts on either side of the DTD interconnect may be bonded together (e.g., under elevated pressure and/or temperature) without the use of intervening solder or an anisotropic conductive material. In some metal-to-metal interconnects, a dielectric material (e.g., silicon oxide, silicon nitride, silicon carbide) may be present between the metals bonded together (e.g., between copper pads or posts that provide the associated conductive contacts). In some embodiments, one side of a DTD interconnect may include a metal pillar (e.g., a copper pillar), and the other side of the DTD interconnect may include a metal contact (e.g., a copper contact) recessed in a dielectric. In some embodiments, a metal-to-metal interconnect (e.g., a copper-to-copper interconnect) may include a noble metal (e.g., gold) or a metal whose oxides are conductive (e.g., silver). In some embodiments, a metal-to-metal interconnect may include metal nanostructures (e.g., nanorods) that may have a reduced melting point. Metal-to-metal interconnects may be capable of reliably conducting a higher current than other types of interconnects; for example, some solder interconnects may form brittle intermetallic compounds when current flows, and the maximum current provided through such interconnects may be constrained to mitigate mechanical failure.

In some embodiments, the dies on either side of a set of DTD interconnects may be bare (e.g., unpackaged) dies.

In some embodiments, the DTD interconnects may include solder. For example, the DTD interconnects may include conductive bumps or pillars (e.g., copper bumps or pillars) attached to the respective conductive contacts by solder. In some embodiments, a thin cap of solder may be used in a metal-to-metal interconnect to accommodate planarity, and this solder may become an intermetallic compound during processing. In some embodiments, the solder used in some or all of the DTD interconnects may have a higher melting point than the solder included in some or all of the DTPS interconnects. For example, when the DTD interconnects in an IC package are formed before the DTPS interconnects are formed, solder-based DTD interconnects may use a higher-temperature solder (e.g., with a melting point above 200° C.), while the DTPS interconnects may use a lower-temperature solder (e.g., with a melting point below 200° C.). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth), tin, silver, bismuth, indium, indium and tin, or gallium.

In some embodiments, a set of DTD interconnects may include an anisotropic conductive material, such as any of the materials discussed above for the DTPS interconnects. In some embodiments, the DTD interconnects may be used as data transfer lanes, while the DTPS interconnects may be used for power and ground lines, among others.

It will be recognized that one more levels of underfill (e.g., organic polymer material such as benzotriazole, imidazole, polyimide, or epoxy) may be provided in an IC package described herein and may not be labeled in order to avoid cluttering the drawings. In various embodiments, the levels of underfill may comprise the same or different insulating materials. In some embodiments, the levels of underfill may comprise thermoset epoxies with silicon oxide particles; in some embodiments, the levels of underfill may comprise any suitable material that can perform underfill functions such as supporting the dies and reducing thermal stress on interconnects. In some embodiments, the choice of underfill material may be based on design considerations, such as form factor, size, stress, operating conditions, etc.; in other embodiments, the choice of underfill material may be based on material properties and processing conditions, such as cure temperature, silicon transition temperature, viscosity and chemical resistance, among other factors; in some embodiments, the choice of underfill material may be based on both design and processing considerations.

In some embodiments, one or more levels of solder resist (e.g., epoxy liquid, liquid photoimageable polymers, dry film photoimageable polymers, acrylics, solvents) may be provided in an IC package described herein and may not be labeled or shown to avoid cluttering the drawings. Solder resist may be a liquid or dry film material including photoimageable polymers. In some embodiments, solder resist may be non-photoimageable.

The terms "substantially," "close," "approximately," "near," and "about," generally refer to being within +/-20% of a target value (e.g., within +/- 5% or 10% of a target value) based on the context of a particular value as described herein or as known in the art.

Terms indicating orientation of various elements, e.g., "coplanar," "perpendicular," "orthogonal," "parallel," or any other angle between the elements, generally refer to being within +/-5%-20% of a target value based on the context of a particular value as described herein or as known in the art.

The term "connected" means a direct connection (which may be one or more of a mechanical, electrical, and/or thermal connection) between the things that are connected, without any intermediary devices, while the term "coupled" means either a direct connection between the things that are connected, or an indirect connection through one or more passive or active intermediary devices.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous.

The disclosure may use perspective-based descriptions such as "above," "below," "top," "bottom," and "side"; such descriptions are used to facilitate the discussion and are not intended to restrict the application of disclosed embodiments.

The terms "over," "under," "between," and "on" as used herein refer to a relative position of one material layer or component with respect to other layers or components. For example, one layer disposed over or under another layer may be directly in contact with the other layer or may have one or more intervening layers. Moreover, one layer disposed between two layers may be directly in contact with one or both of the two layers or may have one or more intervening layers. In contrast, a first layer described to be "on" a second layer refers to a layer that is in direct contact with that second layer. Similarly, unless explicitly stated otherwise, one feature disposed between two features may be in direct contact with the adjacent features or may have one or more intervening layers.

The term "dispose" as used herein refers to position, location, placement, and/or arrangement rather than to any particular method of formation.

The term "between," when used with reference to measurement ranges, is inclusive of the ends of the measurement ranges.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C).

Although certain elements may be referred to in the singular herein, such elements may include multiple sub-elements. For example," an electrically conductive material" may include one or more electrically conductive materials. In another example, "a dielectric material" may include one or more dielectric materials.

Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, reference is made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

The accompanying drawings are not necessarily drawn to scale. Although many of the drawings illustrate rectilinear structures with flat walls and right-angle corners, this is simply for ease of illustration, and actual devices made using these techniques will exhibit rounded corners, surface roughness, and other features.

In the drawings, same reference numerals refer to the same or analogous elements/materials shown so that, unless stated otherwise, explanations of an element/material with a given reference numeral provided in context of one of the drawings are applicable to other drawings where element/materials with the same reference numerals may be illustrated. Further, the singular and plural forms of the labels may be used with reference numerals to denote a single one and multiple ones respectively of the same or analogous type, species, or class of element.

Furthermore, in the drawings, some schematic illustrations of example structures of various devices and assemblies described herein may be shown with precise right angles and straight lines, but it is to be understood that such schematic illustrations may not reflect real-life process limitations which may cause the features to not look so "ideal" when any of the structures described herein are examined using, e.g., images of suitable characterization tools such as scanning electron microscopy (SEM) images, transmission electron microscope (TEM) images, or noncontact profilometer. In such images of real structures, possible processing and/or surface defects could also be visible, e.g., surface roughness, curvature or profile deviation, pit or scratches, not-perfectly straight edges of materials, tapered vias or other openings, inadvertent rounding of corners or variations in thicknesses of different material layers, occasional screw, edge, or combination dislocations within the crystalline region(s), and/or occasional dislocation defects of single atoms or clusters of atoms. There may be other defects not listed here but that are common within the field of device fabrication and/or packaging.

Note that in the figures, various components (e.g., interconnects, conductive contacts, etc.) are shown as aligned (e.g., at respective interfaces) merely for ease of illustration; in actuality, some or all of them may be misaligned. In addition, there may be other components, such as bond pads, landing pads, metallization, etc. present in the assembly that are not shown in the figures to prevent cluttering. Further, the figures are intended to show relative arrangements of the components within their assemblies, and, in general, such assemblies may include other components that are not illustrated (e.g., various interfacial layers or various other components related to optical functionality, electrical connectivity, or thermal mitigation). For example, in some further embodiments, the assembly as shown in the figures may include more dies along with other electrical components. Additionally, although some components of the assemblies are illustrated in the figures as being planar rectangles or formed of rectangular solids, this is simply for ease of illustration, and embodiments of these assemblies may be curved, rounded, or otherwise irregularly shaped as dictated by and sometimes inevitable due to the manufacturing processes used to fabricate various components.

In the drawings, a particular number and arrangement of structures and components are presented for illustrative purposes and any desired number or arrangement of such structures and components may be present in various embodiments.

Further, unless otherwise specified, the structures shown in the figures may take any suitable form or shape according to material properties, fabrication processes, and operating conditions.

The elements of the microelectronic assemblies shown in the accompanying figures may have any suitable dimensions. Only a subset of the accompanying figures are labeled with reference numerals representing dimensions, but this is simply for clarity of illustration, and any of the microelectronic assemblies disclosed herein may have components having the dimensions discussed herein. For example, in some embodiments, the thickness of the base may be between 0.1 millimeters and 1.4 millimeters (e.g., between 0.1 millimeters and 0.35 millimeters, between 0.25 millimeters and 0.8 millimeters, or approximately 1 millimeter).

Various operations may be described as multiple discrete actions or operations in turn in a manner that is most helpful in understanding the claimed subject matter. However, the order of description should not be construed as to imply that these operations are necessarily order dependent. In particular, these operations may not be performed in the order of presentation. Operations described may be performed in a different order from the described embodiment. Various additional operations may be performed, and/or described operations may be omitted in additional embodiments.

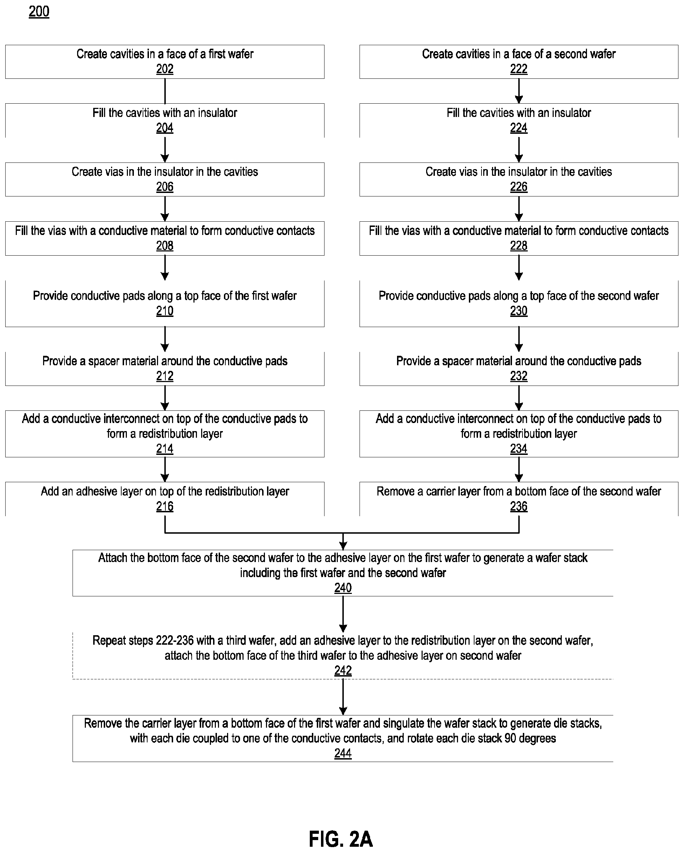

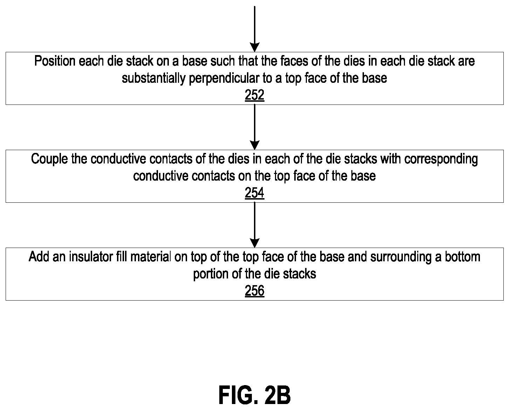

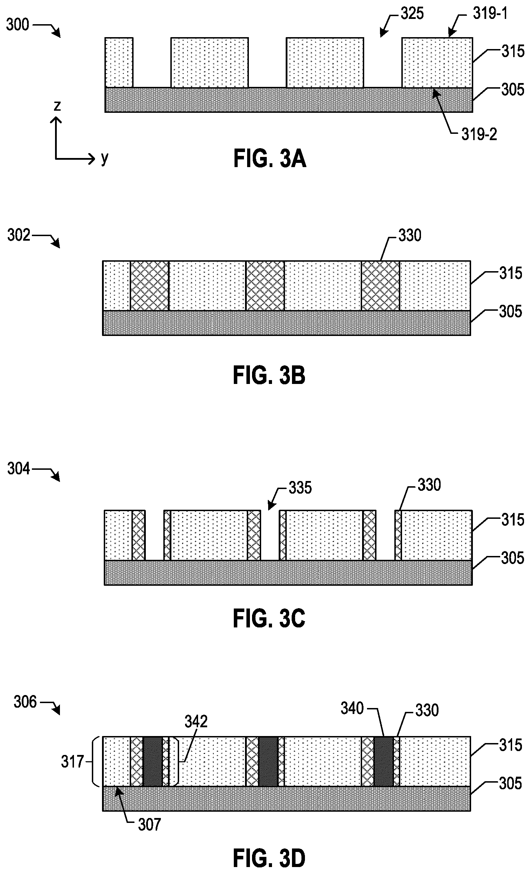

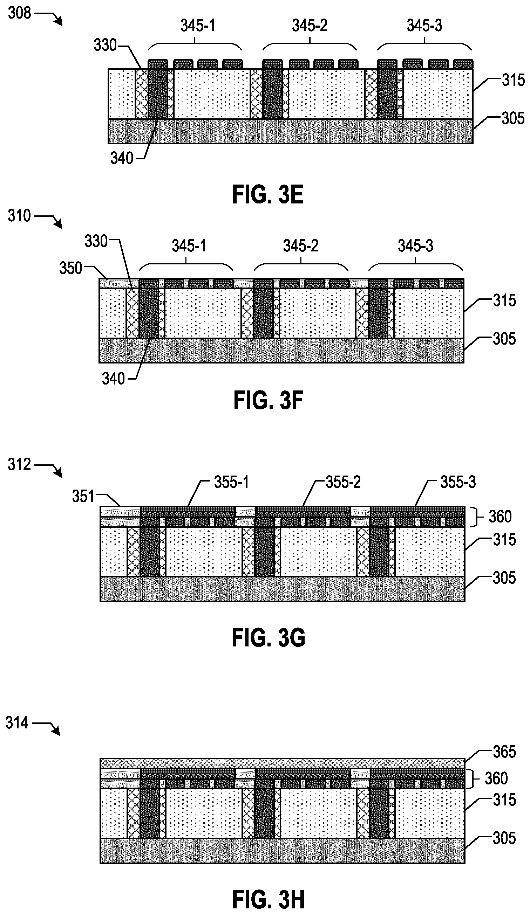

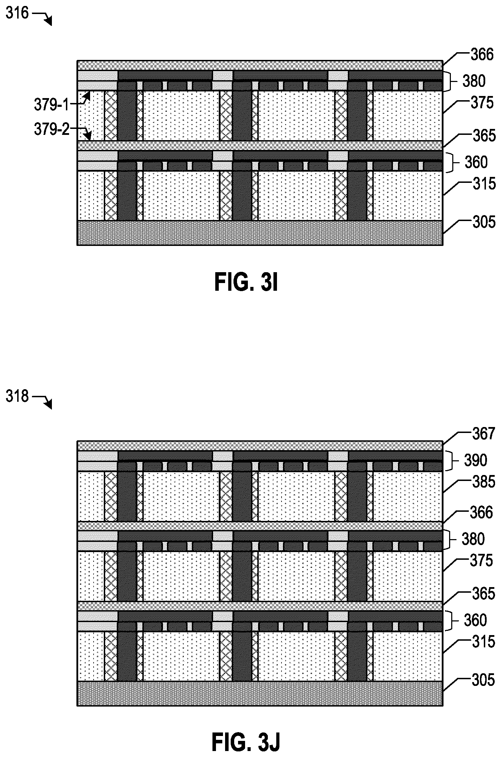

When used to describe a range of dimensions, the phrase "between X and Y" represents a range that includes X and Y. For convenience, the phrase "FIG. 2" may be used to refer to the collection of drawings of FIGS. 2A-2N, the phrase "FIG. 3" may be used to refer to the collection of drawings of FIGS. 3A-3B, etc. Although certain elements may be referred to in the singular herein, such elements may include multiple sub-elements. For example, "an insulating material" may include one or more insulating materials. As used herein, a "conductive contact" may refer to a portion of conductive material (e.g., metal) serving as an electrical interface between different components; conductive contacts may be recessed in, flush with, or extending away from a surface of a component, and may take any suitable form (e.g., a conductive pad or socket, or portion of a conductive line or via).

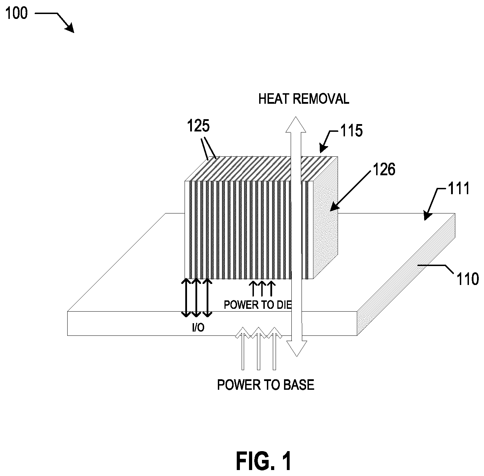

FIG. 1 provides an isometric view of an assembly 100 including dies having redistribution layers and stacked orthogonal to a base, in accordance with some embodiments. In particular, the assembly 100 includes a base 110 and a die stack 115 in which the dies 125 are positioned such that the faces 126 of the dies are orthogonal to a top face 111 of the base 110 (e.g, the dies 125 are disposed such that faces 126 of the dies in the stack are in planes perpendicular to the top face 111 of the base, rather than parallel with the top face 111 the base 110). That is, the die stack 115 is positioned orthogonal to the base 110, in a "sliced bread" type configuration. In some embodiments, the base 110 can be a base die or a substrate, such as a package substrate. When the dies 125 in the die stack 115 are stacked sideways (e.g., orthogonal or perpendicular) to the base 110, each die 125 can be connected directly to the base 110, without connections routed by or through other dies in the die stack 115. Thus, there is direct communication (input/output) between the base 110 and each die 125. Similarly, power can be provided from the base 110 directly to each die 125, without connections routed by or through other dies 125 in the die stack 115. Additionally, by positioning the die stack 115 sideways on the base 110, heat generated by dies 125 in the die stack 115 can be removed more efficiently.

According to some embodiments, the dies 125 in the die stack 115 can each have a redistribution layer on one face 126 of each die 125. Each redistribution layer includes a layer of insulator material in which conductive interconnects (i.e., traces and vias of conductive materials) are distributed to provide electrical connectivity. The electrical connectivity can include connectivity from the base 110 to each die 125 in the die stack115. In general, a redistribution layer is used to re-route contact points from the surface of the base 110 to various points on the die stack 115 die slice 125, which in turn allows higher contact density in the die stack 115. A redistribution layer can be an organic material compatible with the underlying dielectric (e.g., SiN and SiO₂) of the die. The insulator material of a redistribution layer can be a polyimide, a benzocyclobutene (BCB), a polybenzoxaole (PBO) or other insulator material.

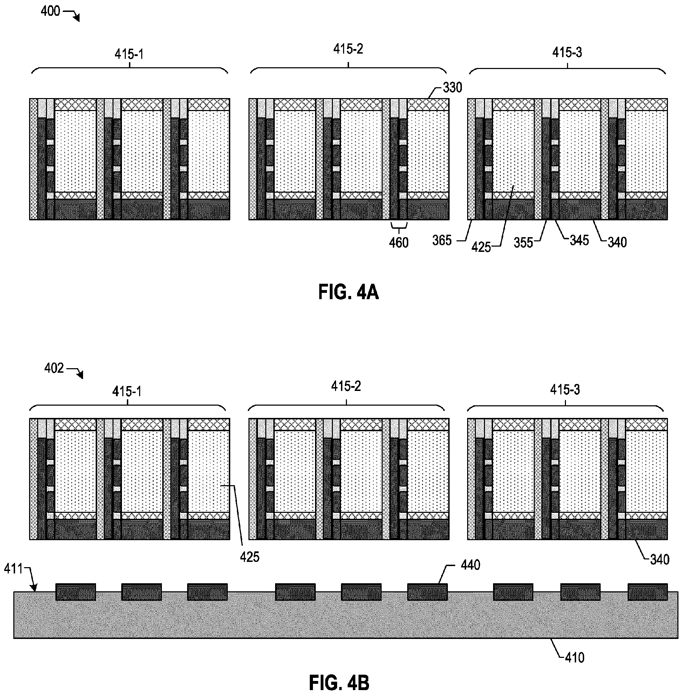

FIGS. 2A-2B show a flow diagram of a method 200 of fabricating a stacked semiconductor die architecture with redistribution layers on dies stacked orthogonal to a base die or substrate, in accordance with some embodiments. FIGS. 3A-2J provide cross-sectional views at various stages in the fabrication of an example stacked semiconductor die architecture according to the method 200 of FIGS. 2A-2B, in accordance with some embodiments. Similarly, FIGS. 4A-4D provide cross-sectional views at various stages in the fabrication of an example stacked semiconductor die architecture with dies stacked orthogonal to a base die or substrate according to the method of FIGS. 2A-2B, in accordance with some embodiments.

Although the operations of the method 200 are illustrated once each and in a particular order, the operations may be performed in any suitable order and repeated as desired. For example, one or more operations may be performed in parallel to fabricate multiple stacked semiconductor dies with redistribution layers on dies stacked orthogonal to a base die or substrate simultaneously. In another example, one or more operations may be performed in parallel to fabricate multiple stacked wafers simultaneously. In addition, the example fabrication method 200 may include other operations not specifically shown in FIG. 2.

The method 200 may begin with a process 202 that includes creating cavities in a face of a first wafer. FIG. 3A shows a cross-sectional view illustrating an assembly 300 that may be an example result of the process 202, including a wafer 315 on a carrier layer 305. The wafer 315 includes multiple cavities 325. The cavities 325 extend from a top face 319-1 to a bottom face 319-2 of the wafer 315. In some embodiments, the cavities 325 extend from the top face 319-1 towards the bottom face 319-2 of the wafer 315, but do not extend all the way through the wafer 315. The cavities can be created using any appropriate fabrication method, such as etching and/or patterning. The method 200 includes a process 222, which may occur in parallel with the process 202 or at a different time. The process 222 is substantially the same as the process 202, and includes creating cavities in a face of a second wafer. In many embodiments, the carrier 305 comprises a layer of any solid material that can withstand the temperatures, pressures, and chemicals used in semiconductor processes; examples of carrier 305 include a semiconductor wafer, a glass wafer, a ceramic wafer, etc. In some embodiments, the carrier may include a glass or silicon carbide material.

Next, the method 200 includes a process 204 of filling the cavities created in the first wafer with an insulator. FIG. 3B illustrates an example result of the process 204, showing an assembly 302 that includes the wafer 315 on the carrier layer 305, with the cavities filled with an insulator 330. The insulator 330 is an insulator material and the insulator 330 may be a dielectric material. The insulator 330 material may be selected to have a coefficient of thermal expansion (CTE) that may mitigate or minimize any stress between the dies and conductive contacts on the dies in the stacked semiconductor die architecture fabricated via the method 200. Stress between the dies and the conductive contacts can arise from uneven thermal expansion in the microelectronic assembly. In some embodiments, the CTE of the insulator material may have a value that is intermediate to the CTE of the conductive contacts and a CTE of the dies. In some embodiments, the insulator 330 may comprise a polyimide, an appropriate epoxy material, such as an epoxy resin, Ajinomoto Buildup Film (ABF), or any other suitable organic material.

Next, the method 200 includes a process 206 of creating vias in the insulator in the cavities. FIG. 3C illustrates an example result of the process 204, showing an assembly 304 that includes the wafer 315 on the carrier layer 305, with the insulator 330 in cavities in the wafer 315, and with cavities 335 in the insulators 330. The cavities in the insulators 330 can be created using any appropriate fabrication method, such as etching and/or patterning.

The method 200 includes a process 208 of filling the cavities in the insulator with conductive material to form conductive contacts. FIG. 3D illustrates an example result of the process 208, showing an assembly 306 that includes the wafer 315 on the carrier 305, with cavities in the wafer 315 filled with insulator 330 and cavities in the insulator 330 filled with conductive material to form conductive contacts 340. The conductive contacts 340 are on the first face 307 of the carrier 305, between areas of insulator 330. In some embodiments, the conductive contacts 340 are evenly spaced apart in the wafer 315. The conductive contacts 340 may include one or more conductive materials such as copper, silver, nickel, gold, platinum, lead, indium, bismuth, or other metals or alloys, for example. The conductive contacts 340 may have a height 342 that is substantially the same as a thickness 317 of the wafer 315. The height 342 may be in a range of about 50 micron to 1.4 millimeters, and in some examples, the height in the range of about 100 micron to 1 millimeter.

Next, the method 200 includes a process 210 of providing conductive pads along a top face of the first wafer. FIG. 3E illustrates an example result of the process 210, showing an assembly 308 that includes the wafer 315 on the carrier 305, the conductive contacts 340 surrounded by insulator 330 in the wafer 315, and conductive pads 345 on the top face 319-1 of the wafer 315. In some embodiments, one or more of the conductive pads 345 can be provided on the conductive contacts 340. In some embodiments, the conductive pads 345 are evenly dispersed along the top face 319-1 of the wafer 315, and in some embodiments, the multiple conductive pads 345 are provided to the right of each conductive contact 340. In some embodiments, as shown in FIG. 3E, the wafer 315 includes three conductive contacts 340-1, 340-2, 340-3, and a set of corresponding conductive pads 345-1, 345-2, 345-3 are provided for each conductive contact 340-1, 340-2, 340-3. The conductive pads 345 may include one or more conductive materials such as copper, silver, nickel, gold, platinum, lead, indium, bismuth, or other metals or alloys, for example.

The method 200 next includes a process 212 of providing a spacer material around the conductive pads. FIG. 3F illustrates an example result of the process 212, showing an assembly 310 that includes the wafer 315 on the carrier 305, the conductive contacts 340 surrounded by insulator 330 in the wafer 315, conductive pads 345 on the top face 319-1 of the wafer 315, and a spacer material 350 around the conductive pads 345. The spacer material 350 is provided on the first face 319-1 of the wafer 315, around the conductive pads 345. The spacer material 350 may also be on a top face of the insulator 330. The spacer material 350 is an insulator material and the spacer material 350 may be a dielectric material. In some embodiments, the spacer material 350 provides stress relief to the wafer 315. In some embodiments, the spacer material 350 provides strain relief to the wafer. The spacer material 350 material may be selected to have a coefficient of thermal expansion (CTE) that may mitigate or minimize any stress between the dies in the stacked semiconductor die architecture fabricated via the method 200. The spacer material 350 material may be selected to have a coefficient of thermal expansion (CTE) that may mitigate or minimize any stress between the dies and the base (e.g., base die or substrate) in the stacked semiconductor die architecture fabricated via the method 200. Stress between the dies and/or between the dies and the base can arise from uneven thermal expansion in the microelectronic assembly. In some embodiments, the CTE of the spacer material 350 may have a value that is intermediate to the CTE of the base and a CTE of the dies. In some embodiments, the spacer material 350 may comprise a polyimide, an appropriate epoxy material, such as an epoxy resin, Ajinomoto Buildup Film (ABF), or any other suitable organic material. In some embodiments, the spacer material 350 may comprise an inorganic material, such as, for example, an oxide.

The method 200 further includes a process 214 of adding conductive interconnects on top of the conductive pads to form a redistribution layer. FIG. 3G illustrates an example result of the process 214, showing an assembly 312 that includes the wafer 315 on the carrier 305, the conductive contacts 340 surrounded by insulator 330 in the wafer 315, conductive pads 345 on the top face 319-1 of the wafer 315, a spacer material 350 around the conductive pads 345 on the top face 319-1 of the wafer, conductive interconnects 355 on top of the conductive pads 345, and additional spacer material 351 between conductive interconnects 355. In some embodiments, each conductive interconnect 355 connects a set of conductive pads 345 extending to the right each conductive contact 340. In various examples, the sets of conductive pads 345 can extend in any selected direction from the conductive contacts 340.

In some embodiments, as shown in FIGS. 3E-3G, the wafer 315 includes three conductive contacts 340-1, 340-2, 340-2, and each conductive contact 340 includes a corresponding set of conductive pads 345-1, 345-2, 345-3. A conductive interconnect 355-1, 355-2, 355-3 is provided on each set of conductive pads 345-1, 345-2, 345-3, connecting the corresponding conductive pads 345-1, 345-2, 345-3 in each set. The spacer material 350, 351, the conductive pads 345, and the conductive interconnects 355 together comprise the redistribution layer 360.

The processes 202-214 of the method 200 can be performed on a first wafer, and similar processes 222-234 of the method 200 can be performed on a second wafer. In some embodiments, the processes 222-234 are performed in parallel with the processes 202-214 to generate a second wafer unit including a redistribution layer.

Next, the method 200 includes a process 216 of adding an adhesive layer on top of the redistribution layer on the first wafer. FIG. 3H illustrates an example result of the process 216, showing an assembly 314 that includes the wafer 315 on the carrier 305, the conductive contacts 340 surrounded by insulator 330 in the wafer 315, the redistribution layer 360, and the adhesive layer 365. The method 200 also includes a process 236 of removing a carrier layer from a bottom face of the second wafer. Thus, in some embodiments, the second wafer includes a redistribution layer on a top face but no carrier layer. In some embodiments, the adhesive layer 255 may be electrically non-conductive. In some embodiments, the adhesive layer 255 may be an epoxy. In some embodiments, the adhesive layer 255 may be an insulator material.

Next, the method 200 includes a process 240 of attaching a bottom face of the second wafer to the adhesive layer on the redistribution layer on the first wafer to generate a wafer stack including the first wafer and the second wafer. The process 240 results in a wafer stack including two wafers and two redistribution layers. FIG. 3I illustrates an example result of the process 240, showing an assembly 316 that includes the first wafer 315 on the carrier 305, the first redistribution layer 360, the adhesive layer 365, the second wafer 375, a second redistribution layer 380, and a second adhesive layer 366. As shown in the assembly 316, the bottom face 379-2 of the second wafer 375 is attached to the adhesive layer 365, while a second redistribution layer 380 is on the top face 379-1 of the second wafer 375.

The method 200 includes a process 242 of repeating steps 222-236 with a third wafer, adding an adhesive layer to the redistribution layer on the second wafer, and attaching the bottom face of the third wafer to the adhesive layer on the second wafer. The process 242 results in a wafer stack including three wafers and three redistribution layers. In various embodiments, the process 242 of the method 200 can be repeated to add additional wafers to the wafer stack. In some embodiments, the number of wafers corresponds to the number of dies in a die stack fabricated using the method 200. FIG. 3J illustrates an example result of the process 242, showing an assembly 318 that includes the first wafer 315 on the carrier 305, the first redistribution layer 360, the adhesive layer 365, the second wafer 375, a second redistribution layer 380, and a second adhesive layer 366, a third wafer 385, a third redistribution layer 390, and a third adhesive layer 367.

Next, the method 200 includes a process 244 of removing the carrier layer from a bottom face of the first wafer, singulating the wafer stack to generate die stacks with each die coupled to one of the conductive contacts, and rotating each die stack 90 degrees. FIG. 4A illustrates an example result of the process 244, showing an assembly 400 that includes three die stacks 415-1, 415-2, 415-3, each die stack 415 having three dies 425. In some embodiments, the wafer stack shown in the assembly 318 is singulated at the left of each conductive contact 340, such that each die in the die stack has a conductive contact 340 and a redistribution layer 460 including the set of conductive pads 345 corresponding to the respective conductive contact 340 and the corresponding conductive interconnect 355. In particular, each die 425 in the assembly 400 has a corresponding redistribution layer 460 that is a portion of one of the redistribution layers 360, 380, 370 from the wafer stack of the assembly 318. Each die 425 also has a layer of insulator 330 between the die 425 and the respective conductive contact 340. Thus, in some embodiments, the redistribution layer 460 enables a side interconnect on each die 425, and the insulator 330 between each die 425 and the respective conductive contact 340 prevents a bottom interconnect. The spacer material 350, 351 is part of each redistribution layer 460 and provides insulation around and between the conductive pads of each redistribution layer 460, and around the conductive interconnect 355 of each redistribution layer 460. Additionally, there is an adhesive layer 365 between the redistribution layer 460 of each selected die 425 in a die stack 415 and the adjacent die 425 in the die stack 415. In some embodiments, the area of a face of a die in the die stack is substantially the same as an area the faces of other dies in the die stack, and the area of a face of a die is about five times to about fifty times larger than an area of an edge of a die, where an edge extends from a first face of a die to a second face of the die.

The method 200 includes a process 252 of positioning each die stack on a base such that the faces of the dies in each die stack are substantially perpendicular to a top face of the base. In some embodiments, the base can be a base die, a substrate, such as a package substrate, or any other suitable base. FIG. 4B illustrates an example result of the process 252, showing an assembly 402 that includes the die stacks 415 and a base 410. The base 410 includes a top face 411 and multiple conductive contacts 440, each respective conductive contact 440 corresponding to a conductive contact 340 in the die stacks 415. In some embodiments, the conductive contacts 440 are on the top face 411 of the base 410. In some embodiments, the conductive contacts 440 are at least partially embedded in the base 410, with a top surface of each conductive contact 440 exposed. In some embodiments, the top surface of each conductive contact 440 is in line with or protruding above the top face 411 of the base 410. The conductive contacts 440 include a conductive material such as copper, silver, nickel, gold, platinum, lead, indium, bismuth, or other metals or alloys, for example.

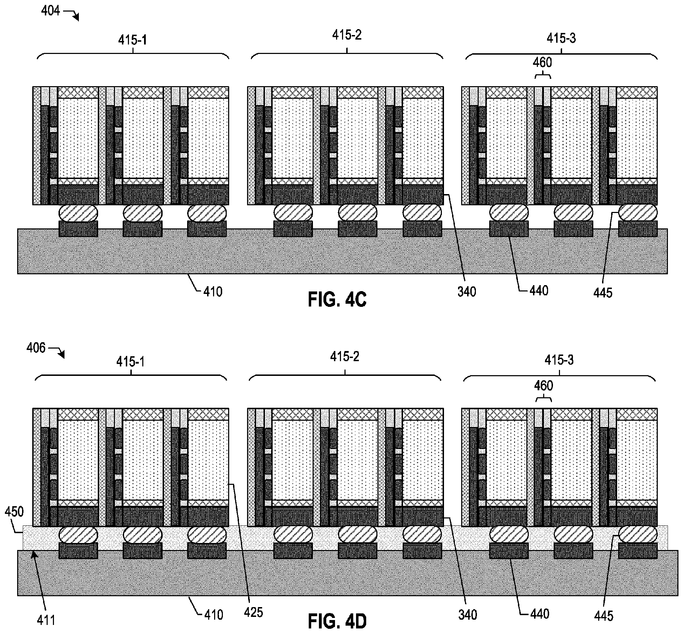

Next, the method 200 includes a process 254 of coupling the conductive contacts of the dies in each of the die stacks with corresponding contacts on the top face of the base. FIG. 4C illustrates an example result of the process 254, showing an assembly 404 including die stacks 415 coupled to the base 410. In particular, the conductive contacts 440 on the top face of the base 410 are coupled to corresponding conductive contacts 340 on the die stacks 415. In some embodiments, the dies in the die stacks 415 may be electrically and mechanically coupled to the base 410 by DTPS or DTD interconnects 445. In particular, the conductive contacts 340 may be electrically and mechanically coupled to corresponding conductive contacts 440 on the top face of the base 410 by the interconnects 445. In some examples, the base 410 is a package substrate. In some examples, the base 410 is a base die. In various examples, the interconnects 445 include solder (e.g., solder bumps or balls). In some embodiments, a portion of the interconnects 445 can be on the base die 410. The interconnects 445 connect the redistribution layers 460 with the conductive contacts 440 on the base die.

Next, the method 200 includes a process 256 of adding an insulator fill material on top of the top face of the base and surrounding a bottom portion of the die stacks. FIG. 4D illustrates an example result of the process 256, showing an assembly 406 including the die stacks 415 coupled to the base 410 with an insulator material 450 around a portion of the die stacks 415 on the top face 411 of the base 410. The insulator material 450 may be a mold underfill. In some embodiments, the insulator material 450 may extend to the conductive contacts 340, and in some embodiments, the insulator material 450 above the conductive contacts 340. In some embodiments, the insulator material 450 may extend from the top face 411 of the base 410 up to the die stacks 415 around the interconnects 445; in such embodiments, the insulator material 450 may serve as an underfill material. In some embodiments, the insulator material 450 may extend between the top face 411 of the base 410 up between the die stacks 415 around the associated interconnects 445 and further up beyond the conductive contacts 340; in such embodiments, the insulator material 450 may serve as an underfill material. The insulator material 450 may include multiple different insulator materials (e.g., an underfill material, and a different overmold material). The insulator material 450 may be an insulating material, such as an appropriate epoxy material. In some embodiments, the insulator material 450 may include an underfill material that is an epoxy flux that assists with attaching the die stacks 415 to the base 410, and polymerizes and encapsulates the interconnects 445. The insulator material 450 may be selected to have a coefficient of thermal expansion (CTE) that may mitigate or minimize the stress between the dies 425 in the die stacks 415 and the base 410 arising from uneven thermal expansion in the microelectronic assembly 406. In some embodiments, the CTE of the insulator material 450 may have a value that is intermediate to the CTE of the base 410 (e.g., the CTE of the dielectric material of the base 410) and a CTE of the dies 425 in the die stacks 415.

In some embodiments, the microelectronic assembly 406 of FIG. 4D may also include a heat spreader. The heat spreader may be used to move heat away from the dies stacks 415 (e.g., so that the heat may be more readily dissipated by a heat sink or other thermal management device). The heat spreader may include any suitable thermally conductive material (e.g., metal, appropriate ceramics, etc.), and may include any suitable features (e.g., fins). In some embodiments, the heat spreader may be an integrated heat spreader.

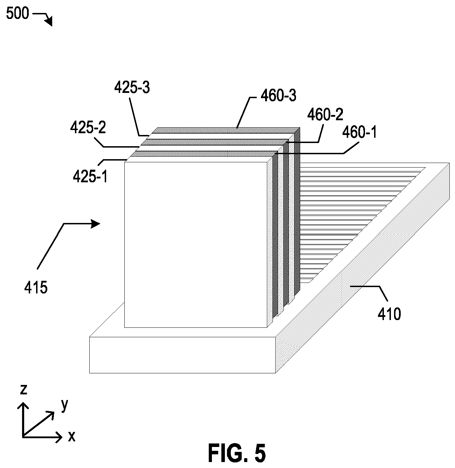

FIG. 5 provides an isometric view of an assembly 500 including a die stack 415 coupled to a base 410 (e.g., a base die or substrate), with dies 425-1, 425-2, 425-3 stacked orthogonal to the base 410, in accordance with some embodiments. As shown in FIG. 5, a die stack 415 includes multiple dies 425 with redistribution layers 460 in between the dies 425. For example, in FIG. 5, a first redistribution layer 460-1 is between a first die 425-1 and a second die 425-2, and a second redistribution layer 460-2 is between the second die 425-2 and a third die 425-3. The example die stack 415 includes three dies 425. In other embodiments, the die stack 415 includes more than three dies 425. In some embodiments, the assembly 500 is fabricated according to the method 200 of FIGS. 2A-2B.

Various embodiments of microelectronic assemblies having dies with redistribution layers and stacked orthogonal to a base, described above may, advantageously, be easily fabricated in parallel with conventional manufacturing techniques for package substrates. Various arrangements of the microelectronic assemblies and die stacks as shown in FIGS. 1-5 do not represent an exhaustive set of microelectronic assemblies having redistribution layers on dies stacked orthogonal to a base die or substrate as described herein may be implemented, but merely provide some illustrative examples. In particular, the number and positions of various elements shown in FIGS. 1-5 is purely illustrative and, in various other embodiments, other numbers of these elements, provided in other locations relative to one another may be used in accordance with the general architecture considerations described herein. For example, although not specifically shown in the present drawings, in some embodiments, a microelectronic assembly may include a redistribution layer (RDL) between any pair of layers in die stacks 285, the RDL including a plurality of interconnect structures (e.g., conductive lines and conductive vias) to assist routing of signals and/or power between components. In another example, although also not specifically shown in the present drawings, in some embodiments, a package substrate of a microelectronic assembly may include one or more recesses. In such embodiments, a bottom face of a recess in the package substrate may be provided by the solid material of the package substrate. A recess may be formed in a package substrate in any suitable manner (e.g., via three-dimensional printing, laser cutting or drilling the recess into an existing package substrate, etc.). At least a portion of the substrate or the base die may be positioned over or at least partially in such a recess. In yet another example, features of any one of FIGS. 1-5 may be combined with features of any other one of FIGS. 1-5. For example, in some embodiments, a die stack can include more than three layers, and the coupling between the die stack and the base can have different arrangements.

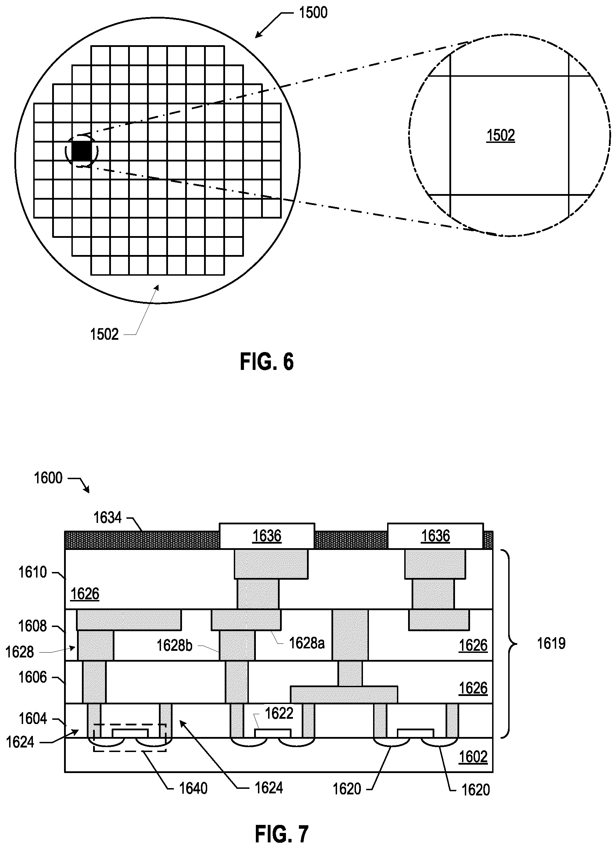

The microelectronic assemblies disclosed herein, in particular the stacked semiconductor die architectures having redistribution layers on dies stacked orthogonal to a base die or substrate, may be included in any suitable electronic component. FIGS.6-9 illustrate various examples of apparatuses that may include, or be included in, any of the microelectronic assemblies and/or stacked semiconductor architectures disclosed herein.

FIG. 6 is a top view of a wafer 1500 and dies 1502 that may be included in any of the microelectronic assemblies as described herein. For example, a die 1502 may be any of the dies described herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 7, discussed below) and/or supporting circuitry to route electrical signals to the transistors, as well as any other IC components. In some embodiments, the wafer 1500 or the die 1502 may include a memory device (e.g., a randomaccess memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 7) or other logic that is configured to store information in the memory devices or execute instructions stored in the memory array.

FIG. 7 is a side, cross-sectional view of an IC device 1600 that may be included in any of the microelectronic assemblies as described herein. For example, an IC device 1600 may be provided on/in any of the dies and/or die stacks described herein. The IC device 1600 may be formed on a substrate 1602 (e.g., the wafer 1500 of FIG. 6) and may be included in a die (e.g., the die 1502 of FIG. 6). The substrate 1602 may be a semiconductor substrate composed of semiconductor material systems including, for example, N-type or P-type materials systems (or a combination of both). The substrate 1602 may include, for example, a crystalline substrate formed using a bulk silicon or a silicon-on-insulator substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group III-V materials (i.e., materials from groups III and V of the periodic system of elements), group II-VI (i.e., materials from groups II and IV of the periodic system of elements), or group IV materials (i.e., materials from group IV of the periodic system of elements) may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 6) or a wafer (e.g., the wafer 1500 of FIG. 6).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 7 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one P-type work function metal or N-type work function metal, depending on whether the transistor 1640 is to be a P-type metal oxide semiconductor (PMOS) or an N-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top face of the substrate. In other embodiments, at least one of the metal layers that form the gate electrode may simply be a planar layer that is substantially parallel to the top face of the substrate and does not include sidewall portions substantially perpendicular to the top face of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 7 as interconnect layers 1606, 1608, and 1610). For example, electrically conductive features of the device layer 1604 (e.g., the gate 1622 and the S/D contacts 1624) may be electrically coupled with the interconnect structures 1628 of the interconnect layers 1606, 1608, and 1610. The one or more interconnect layers 1606, 1608, and 1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 7). Although a particular number of interconnect layers 1606, 1608, and 1610 is depicted in FIG. 7, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in a direction of a plane that is substantially parallel with a surface of the substrate 1602 upon which the device layer 1604 is formed. For example, the lines 1628a may route electrical signals in a direction in and out of the page from the perspective of FIG. 7. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606, 1608, and 1610 together.

The interconnect layers 1606, 1608, and 1610 may include a dielectric material 1626 disposed between the interconnect structures 1628, as shown in FIG. 7. In some embodiments, the dielectric material 1626 disposed between the interconnect structures 1628 in different ones of the interconnect layers 1606, 1608, and 1610 may have different compositions; in other embodiments, the composition of the dielectric material 1626 between different interconnect layers 1606, 1608, and 1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606, 1608, and 1610. In FIG. 7, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606, 1608, and 1610; for example, the conductive contacts 1636 may include other analogous features (e.g., posts) that route the electrical signals to external components.

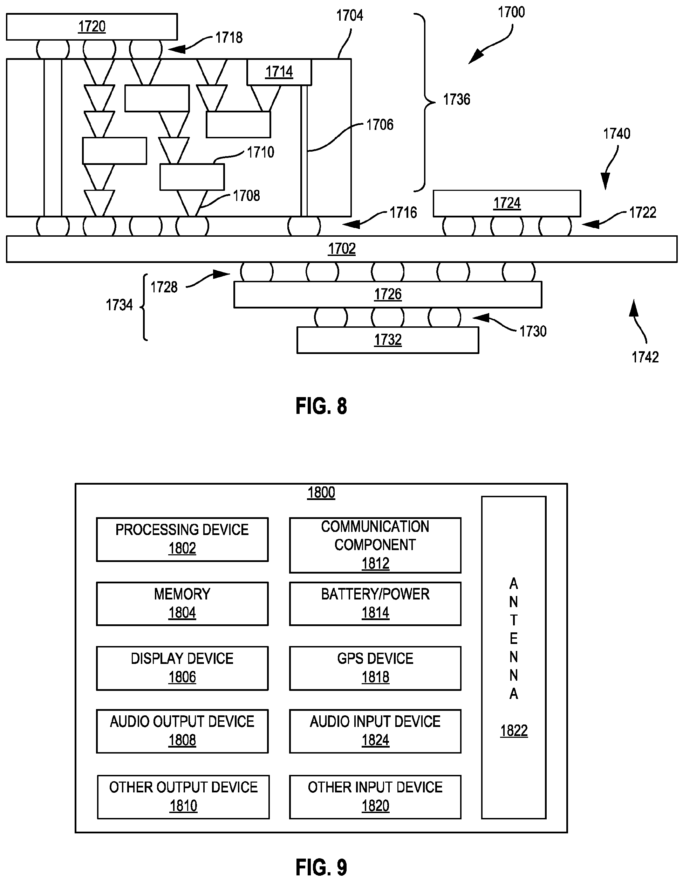

FIG. 8 is a side, cross-sectional view of an IC device assembly 1700 that may include a stacked semiconductor die architecture having dies with redistribution layers and stacked orthogonal to a base die or substrate in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the microelectronic assemblies discussed above, and/or may include one or more die stacks having redistribution layers on dies stacked orthogonal to a base die or substrate as discussed with reference to FIGS. 1-5.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 8 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 8), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 8, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 5), an IC device (e.g., any of the IC devices described herein, or any combination of such IC devices), or any other suitable component. Generally, the package interposer 1704 may spread a connection to a wider pitch or re-route a connection to a different connection. For example, the package interposer 1704 may couple the IC package 1720 (e.g., a die) to a set of ball grid array (BGA) conductive contacts of the coupling components 1716 for coupling to the circuit board 1702. In the embodiment illustrated in FIG. 8, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as stacked semiconductor die architectures with redistribution layers on dies stacked orthogonal to a base die or substrate as described herein. In some embodiments, the package interposer 1704 may be formed as a PCB. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. In any of these embodiments, the package interposer 1704 may include multiple metal layers separated from one another by layers of dielectric material and interconnected by electrically conductive vias. The package interposer 1704 may include metal lines 1710 and vias 1708, including but not limited to conductive vias 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 8 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 9 is a block diagram of an example communication device 1800 that may include one or more microelectronic assemblies and/or stacked semiconductor die architectures having redistribution layers on dies stacked orthogonal to a base die or substrate in accordance with any of the embodiments disclosed herein. A handheld communication device or a laptop communication device may be examples of the communication device 1800. Any suitable ones of the components of the communication device 1800 may include one or more of the microelectronic assemblies discussed herein, IC packages 1720, 1724, IC device assemblies 1700, IC devices 1600, or dies 1502 disclosed herein. In particular, any suitable ones of the components of the communication device 1800 may include one or more semiconductor die architectures with redistribution layers on dies stacked orthogonal to a base as described herein, e.g., as a part of a microelectronic assembly as described herein. A number of components are illustrated in FIG. 7 as included in the communication device 1800, but any one or more of these components may be omitted or duplicated, as suitable for the application. In some embodiments, some or all of the components included in the communication device 1800 may be attached to one or more motherboards. In some embodiments, some or all of these components are fabricated onto a single system-on-a-chip (SoC) die.

Additionally, in various embodiments, the communication device 1800 may not include one or more of the components illustrated in FIG. 7, but the communication device 1800 may include interface circuitry for coupling to the one or more components. For example, the communication device 1800 may not include a display device 1806, but may include display device interface circuitry (e.g., a connector and driver circuitry) to which a display device 1806 may be coupled. In another set of examples, the communication device 1800 may not include an audio input device 1824 or an audio output device 1808, but may include audio input or output device interface circuitry (e.g., connectors and supporting circuitry) to which an audio input device 1824 or audio output device 1808 may be coupled.

The communication device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The communication device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic RAM (STT-MRAM).

In some embodiments, the communication device 1800 may include a communication module 1812 (e.g., one or more communication modules). For example, the communication module 1812 may be configured for managing wireless communications for the transfer of data to and from the communication device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication module 1812 may be, or may include, any of the microelectronic assemblies disclosed herein.

The communication module 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication module 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication module 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication module 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication module 1812 may operate in accordance with other wireless protocols in other embodiments. The communication device 1800 may include an antenna 1822 to facilitate wireless communications and/or to receive other wireless communications (such as AM or FM radio transmissions). The antenna 1822 may include one or more semiconductor die architectures with redistribution layers on dies stacked orthogonal to a base as described herein, e.g., as a part of a microelectronic assembly as described herein.

In some embodiments, the communication module 1812 may manage wired communications, such as electrical, optical, or any other suitable communication protocols (e.g., the Ethernet). As noted above, the communication module 1812 may include multiple communication modules. For instance, a first communication module 1812 may be dedicated to shorter-range wireless communications such as Wi-Fi or Bluetooth, and a second communication module 1812 may be dedicated to longer-range wireless communications such as global positioning system (GPS), EDGE, GPRS, CDMA, WiMAX, LTE, EV-DO, or others. In some embodiments, a first communication module 1812 may be dedicated to wireless communications, and a second communication module 1812 may be dedicated to wired communications. In some embodiments, the communication module 1812 may support millimeter wave communication.

The communication device 1800 may include battery/power circuitry 1814. The battery/power circuitry 1814 may include one or more energy storage devices (e.g., batteries or capacitors) and/or circuitry for coupling components of the communication device 1800 to an energy source separate from the communication device 1800 (e.g., AC line power).

The communication device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The communication device 1800 may include an audio output device 1808 (or corresponding interface circuitry, as discussed above). The audio output device 1808 may include any device that generates an audible indicator, such as speakers, headsets, or earbuds.

The communication device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The communication device 1800 may include a GPS device 1818 (or corresponding interface circuitry, as discussed above). The GPS device 1818 may be in communication with a satellite-based system and may receive a location of the communication device 1800, as known in the art.

The communication device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The communication device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The communication device 1800 may have any desired form factor, such as a handheld or mobile communication device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop communication device, a server or other networked computing component, a printer, a scanner, a monitor, a set-top box, an entertainment control unit, a vehicle control unit, a digital camera, a digital video recorder, or a wearable communication device. In some embodiments, the communication device 1800 may be any other electronic device that processes data.

The following paragraphs provide examples of various ones of the embodiments disclosed herein.

Example 1 provides a microelectronic assembly, including a base die having a top face, where the base is one of a substrate and a base die; a die stack including: a first die having a first face, a second face, and a bottom edge extending between the first face and the second face, a conductive contact on the bottom edge of the first die, a redistribution layer on the first face of the first die coupled to the conductive contact, a second die having a first face and a second face opposite the first face, the second face of the second die parallel to the first face of the first die, and where the die stack is coupled to the top face of the base die; and a solder on the base, where the conductive contact is coupled to the solder; where the first face of the first die and the second face of the second die are substantially perpendicular to the top face of the base.

Example 2 provides the microelectronic assembly of example 1, where the first die is a memory die.

Example 3 provides the microelectronic assembly of any of examples 1-2, where the redistribution layer includes a plurality of interconnected conductive pads.

Example 4 provides the microelectronic assembly of any of examples 1-3, further including an adhesive between the spacer layer and the second face of the second die.

Example 5 provides the microelectronic assembly of example 4, where the adhesive is an insulator material.

Example 6 provides the microelectronic assembly of any of examples 1-3, further including an insulator material between the spacer layer and the second face of the second die.

Example 7 provides the microelectronic assembly of example 1, further including an insulator material between the bottom edge of the first die and the conductive contact.

Example 8 provides the microelectronic assembly of any of examples 1-7, where the conductive contact is a first conductive contact and further including a base conductive contact on the top face of the base.

Example 9 provides the microelectronic assembly of example 8, where the solder is coupled to the base conductive contact.

Example 10 provides the microelectronic assembly of any of examples 1-9, where the redistribution layer includes a copper material.

Example 11 provides the microelectronic assembly of any of examples 1-10, where the redistribution layer includes a patterned conductive material.

Example 12 provides the microelectronic assembly of example 1-11, further including a spacer layer between the redistribution layer and the second face of the second die, where the spacer layer is between about one tenth and one times a width of the first die.

Example 13 provides the microelectronic assembly according to any of examples 12, where the spacer layer is between about one tenth and one times the width of the first die.

Example 14 provides the microelectronic assembly according to any of examples 1-13, where an area of the first face of the first die is substantially the same as an area of the second face of the first die, and where the area of the first face of the first die is about five times to about fifty times larger than an area of the bottom edge of the first die.

Example 15 provides the microelectronic assembly according to any of examples 1-12, further including an insulator material on the base and around a portion of the die stack.

Example 16 provides the method according to example 15, where the insulator material provides stress relief to the die stack.

Example 17 provides the method according to example 15, where the insulator material provides strain relief to the die stack.

Example 18 provides a microelectronic assembly, including a die stack including: a first die having a first face and a second face opposite the first face, and a bottom edge extending between the first face and the second face of the first die, a redistribution layer on the first face of the first die, a second die having a first face and a second face opposite the first face, the second face of the second die parallel to the first face of the first die, and a spacer layer between the first face of the first die and the second face of the second die; a base having a top face and a conductive contact, where the bottom edge of the first die is substantially parallel to the top face of the base, and the first face of the first die and the second face of the second die are substantially perpendicular to the top face of the base; and a solder coupled to the conductive contact and the redistribution layer.

Example 19 provides the microelectronic assembly of example 18, where the conductive contact is a base conductive contact and where the die stack further includes a first conductive contact at the bottom edge of the first die coupled to the redistribution layer.

Example 20 provides the microelectronic assembly of example 19, where the solder is between the base conductive contact and the first conductive contact.

Example 21 provides the microelectronic assembly of any of examples 18-19, where the first conductive contact is between the bottom edge of the first die and the top face of the base.

Example 22 provides the microelectronic assembly of any of examples 18-21, where the redistribution layer includes a plurality of conductive pads.

Example 23 provides the microelectronic assembly of example 22, where the plurality of conductive pads are interconnected.

Example 24 provides the microelectronic assembly of any of examples 18-23, where the redistribution layer is in the spacer layer and where the spacer layer is an insulator material.

Example 25 provides the microelectronic assembly of any of examples 18-24, where the redistribution layer includes copper.

Example 26 provides the microelectronic assembly of any of examples 18-25, further including an adhesive layer between the spacer layer and the second face of the second die.

Example 27 provides a method of fabricating a microelectronic assembly, the method including providing a die stack including: a first die having a first face, a second face, and a bottom edge extending between the first face and the second face, a first conductive contact adjacent to the bottom edge of the first die, a redistribution layer on the first face of the first die, the redistribution layer coupled to the first conductive contact, a second die having a first face and a second face opposite the first face, the second face of the second die parallel to the first face of the first die; and positioning the die stack on a top face of a base, with the first face of the first die and the second face of the second die substantially perpendicular to the top face of the base; and coupling the first conductive contact with a base conductive contact on the base.

Example 28 provides the method of example 27, further including providing a solder between the first conductive contact and the base conductive contact.

Example 29 provides the method according to any of examples 27-28, further including providing an insulator material on the top face of the base and around a bottom edge of the first die.

Example 30 provides the method according to any of examples 27-29, further including providing an adhesive between the spacer layer and the second face of the second die.

Example 31 provides the method according to any of examples 27-30, further including providing an insulator material between the first conductive contact and the second face of the second die.

Example 32 provides the method according to example 31, where the insulator material provides stress relief to the microelectronic assembly.

Example 33 provides the method according to example 31, where the insulator material provides strain relief to the microelectronic assembly.

Example 34 provides a process of making a semiconductor package substrate, the process comprising providing a die stack including: a first die having a first face, a second face, and a bottom edge extending between the first face and the second face, a first conductive contact adjacent to the bottom edge of the first die, a redistribution layer on the first face of the first die, the redistribution layer coupled to the first conductive contact, a second die having a first face and a second face opposite the first face, the second face of the second die parallel to the first face of the first die, and positioning the die stack on a top face of a base, with the first face of the first die and the second face of the second die substantially perpendicular to the top face of the base; and coupling the first conductive contact with a base conductive contact on the base.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a base having a top face, wherein the base is one of a substrate and a base die;
a die stack including:
a first die having a first face, a second face, and a bottom edge extending between the first face and the second face,
a conductive contact on the bottom edge of the first die,
a redistribution layer on the first face of the first die coupled to the conductive contact, and
a second die having a first face and a second face opposite the first face, the second face of the second die parallel to the first face of the first die;
wherein the die stack is coupled to the top face of the base; and
a solder on the base, wherein the conductive contact is coupled to the solder;
wherein the first face of the first die and the second face of the second die are substantially perpendicular to the top face of the base.

2. The microelectronic assembly of claim 1, wherein the first die is a memory die.

3. The microelectronic assembly of any one of claims 1-2, wherein the redistribution layer includes a plurality of interconnected conductive pads.

4. The microelectronic assembly of any one of claims 1-3, further comprising an adhesive between the redistribution layer and the second face of the second die.

5. The microelectronic assembly of claim 4, wherein the adhesive is an insulator material.

6. The microelectronic assembly of any one of claims 1-3, further comprising an insulator material between the bottom edge of the first die and the conductive contact.

7. The microelectronic assembly of any one of claims 1-6,wherein the conductive contact is a first conductive contact and further comprising a base conductive contact on the top face of the base.

8. The microelectronic assembly of claim 7, wherein the solder is coupled to the base conductive contact.

9. The microelectronic assembly of any one of claims 1-8, wherein the redistribution layer includes a copper material.

10. The microelectronic assembly of any one of claims 1-9, wherein the redistribution layer includes a patterned conductive material.

11. The microelectronic assembly of any one of claims 1-10, further comprising a spacer layer between the redistribution layer and the second face of the second die, wherein the spacer layer is between about one tenth and one times a width of the first die.

12. The microelectronic assembly of any one of claims 1-11, wherein an area of the first face of the first die is substantially the same as an area of the second face of the first die, and wherein the area of the first face of the first die is about five times to about fifty times larger than an area of the bottom edge of the first die.

13. The microelectronic assembly of any one of claims 1-11, further comprising an insulator material on the base and around a portion of the die stack.

14. A process of making a semiconductor package substrate, the process comprising:
providing a die stack including:
a first die having a first face, a second face, and a bottom edge extending between the first face and the second face,
a first conductive contact adjacent to the bottom edge of the first die,
a redistribution layer on the first face of the first die, the redistribution layer coupled to the first conductive contact,
a second die having a first face and a second face opposite the first face, the second face of the second die parallel to the first face of the first die, and
positioning the die stack on a top face of a base, with the first face of the first die and the second face of the second die substantially perpendicular to the top face of the base; and
coupling the first conductive contact with a base conductive contact on the base.

15. The process of claim 14, further comprising providing a solder material between the first conductive contact and the base conductive contact.
